(19) Europäisches Patentamt

European Patent Office

Office européen des brevets

(11) **EP 3 567 722 A1**

(12) **EUROPEAN PATENT APPLICATION**

(43) Date of publication:
**13.11.2019 Bulletin 2019/46**

(21) Application number: **18171555.8**

(22) Date of filing: **09.05.2018**

(51) Int Cl.:
*H03F 3/217* (2006.01)     *H03M 3/00* (2006.01)
*H03F 1/02* (2006.01)     *H03F 1/32* (2006.01)
*H03F 3/185* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ams AG
8141 Premstätten (AT)**

(72) Inventors:
• **Auer, Mario
  8042 Graz (AT)**
• **Karaca, Timucin
  8051 Graz (AT)**

(74) Representative: **Epping - Hermann - Fischer
Patentanwaltsgesellschaft mbH
Schloßschmidstraße 5
80639 München (DE)**

(54) **CLASS-D AMPLIFIER AND METHOD FOR GENERATING A DRIVER SIGNAL**

(57) A Class-D amplifier for generating a driver signal from a multi-bit input signal comprises a digital pulse-width modulation, PWM, stage (DPWM) that is configured to generate a PWM signal (PWMA, PWMB) from the multi-bit input signal and a digital error feedback signal, and a power stage (PS) comprising a push-pull amplifier being controlled by the PWM signal (PWMA, PWMB) for generating the driver signal. A feedback stage (FB) generates the error feedback signal based on a difference between the driver signal and the PWM signal (PWMA, PWMB).

## Fig 1

EP 3 567 722 A1

**Description**

The present disclosure relates to a Class-D amplifier and to a method for generating a driver signal, in particular a driver signal for a speaker, from a multi-bit input signal.

Class-D amplifiers are well-known for their high power efficiency. They are used in a variety of applications, ranging from home entertainment systems, automotive audio, to professional sound equipment. More recently, also application in mobile audio equipment has become popular. However, such devices like tablets, smartphones and the like are constrained by a limited energy storage. It has been found that with reduced power, small parasitic effects take place, Furthermore, better power efficiency is generally desired in mobile applications.

An object to be achieved is to provide an improved amplification concept that provides a high amplification quality and efficient power usage.

This object is achieved with the subject-matter of the independent claims. Embodiments and developments are subject of the dependent claims.

In a Class-D amplifier with a multi-bit input signal, a digital pulse-width modulation, PWM, is performed to generate a PWM signal for driving a power stage of the amplifier. The improved amplification concept is based on the idea that a deviation between the PWM signal and an output of the power stage is measured as an error feedback signal and provided back to the digital PWM. This allows to correct errors introduced by system imminent delays in the power stage, that comprises at least one push-pull amplifier, e.g. a pair of serially connected complementary transistors, in particular MOS transistors. While this feedback approach generally works with digital pulse-width modulation, in some implementations the digital PWM may be implemented with a down-sampled feedback of the output PWM signal to the input of the digital PWM stage. For example, a single stage decimator is used for such feedback. The digital PWM may perform noise shaping.

For example, according to one embodiment, a Class-D amplifier for generating a driver signal, in particular a driver signal for a speaker, from a multi-bit input signal comprises a digital PWM stage that is configured to generate a PWM signal from the multi-bit input signal and a digital error feedback signal, in particular a combination of the latter signals. The amplifier further comprises a power stage comprising at least one push-pull amplifier, e.g. a pair of serially connected complementary transistors, in particular MOS transistors, being controlled by the PWM signal for generating the driver signal. For example, the push-pull amplifier or the serial connection of the complementary transistors, e.g. a CMOS stage, is connected between a positive supply terminal and a ground terminal or between a pair of voltage supply terminals.

A feedback stage is configured to generate the error feedback signal based on a difference between the driver signal and the PWM signal. For example, the feedback stage is configured to generate the error feedback signal by generating an analog difference signal by forming a difference between the driver signal and an analog representation of the PWM signal. The feedback stage further amplifies the analog difference signal with a first scaling factor, converts the amplified analog difference signal to a digital difference signal, e.g. with an analog-to-digital converter, ADC, and provides the error feedback signal as a result of a digital amplification of the digital difference signal with a second scaling factor that is equal or approximately equal to an inverse of the first scaling factor.

As the analog difference signal is expected to have a small amplitude, in particular with respect to a signal amplitude of the input signal, the amplification with the first scaling factor allows the sensitivity requirements of the analog-to-digital conversion to be reduced. In particular, noise and linearity requirements of the ADC in the feedback stage are relaxed. In order to revert this amplification in the analog domain, a digital amplification with the inverse or approximately the inverse of the first scaling factor is performed to bring the feedback signal to the appropriate level of the input signal. While exactly the inverse value for the second scaling factor is desirable, process variations of elements in the analog amplification may lead to small deviations from nominal values such that the second scaling factor is only approximately the inverse of the first scaling factor.

For example, for generating the digital difference signal the feedback stage comprises a delta-sigma analog-to-digital converter, ADC, in particular a continuous time delta-sigma ADC. The ADC may be built as a single bit ADC with resistive feedback digital-to-analog converter, DAC.

The feedback stage may comprises a PWM DAC comprising a further push-pull amplifier, e.g. a further pair of serially connected complementary transistors, being controlled by the PWM signal for generating the analog representation of the PWM signal. For example, compared to transistors of the power stage, transistors of the PWM DAC are dimensioned for smaller powers and achieve a faster and more accurate conversion of the digital PWM signal accordingly. If the ADC in the feedback stage is implemented as a delta-sigma ADC, a digital feedback within the delta-sigma ADC can be implemented with a similar structure of a push-pull amplifier, e.g. a serially connected complementary transistor pair, for converting the digital feedback of the delta-sigma ADC to the input, e.g. an ADC input stage of the delta-sigma ADC.

As mentioned above, small deviations between the first and the second scaling factor with respect to an ideal inverse can occur. Accordingly, in some implementations, the feedback stage is configured to, during a calibration mode of operation, e.g. during a startup calibration, determine an actual value of the first scaling factor and to set the second scaling factor to a value that is equal or approximately equal to an inverse of the actual value of the first scaling factor. An ideal inverse may still not be achieved due to numerical limitations. For example, a well-known PWM signal is used during the calibration mode of operation to determine the actual value of the first analog scaling factor.

A sufficient linearity of the digital PWM may be desired. This could be achieved, for example with non-linear predistortion of the input signal that matches the non-linear behavior of a conventional digital PWM stage. However, such digital preprocessing, i.e. predistortion, requires high computational effort which increases power consumption of the overall arrangement. A more power efficient approach with a high linearity is described in the following.

For example, the digital PWM stage comprises a first input for receiving the multi-bit input signal and a second input for receiving the error feedback signal. A digital filter is coupled to the first input, to the second input and to a PWM feedback terminal. A sampling element is connected downstream of the digital filter. A PWM generator is connected downstream of the sampling element for outputting the PWM signal. The digital PWM stage further comprises a single stage decimator for providing a PWM signal to the PWM feedback terminal with a reduced sampling rate. The single stage decimator may be implemented with a cascaded integrator-comb, CIC, filter, in particular with a single-stage CIC filter. The single-stage approach achieves that low latency is introduced in the feedback of the digital PWM stage, which avoids feedback-induced instabilities of the PWM stage. The CIC implementation, for example, can be implemented with little effort and good power efficiency.

Specific processing rates or clock rates may be used for the single elements of the digital PWM stage. For example, the sampling element is configured to process an output of the digital filter with a first processing rate. The digital filter is configured to process the input signal reduced by the error feedback signal and the PWM signal at the PWM feedback terminal at a second processing rate, which is the reduced sampling rate provided by the single stage decimator. It should be noted that operating the digital filter with a reduced sampling rate keeps power consumption low. The PWM generator is configured to output the PWM signal with a third processing rate. In such a configuration the second processing rate is higher than the first processing rate and lower than the third processing rate. For example, the third processing rate, i.e. the rate of the PWM signal at the output of the digital PWM stage, is 100 MHz. The first processing rate of the input signal may be 390,625 KHz which is $1/2^8$ of the third processing rate. In some implementations, the digital PWM stage may comprise an upsampling stage coupled between the first input and the digital filter, increasing the processing rate of the input signal. The second processing rate results from the third processing rate divided by a downsampling factor of the single stage decimator. An example value for the downsampling factor may be 8.

In the disclosure above, the amplifier has been described as a single-ended Class-D amplifier. In particular for mobile applications, it may be desirable to implement the Class-D amplifier in differential form. The differential approach may provide higher power efficiency.

Accordingly, in some implementations the digital PWM stage is configured to output the PWM signal as a differential signal. The power stage comprises the push-pull amplifier being a first push-pull amplifier and further comprises a second push-pull amplifier, e.g. a second pair of serially connected complementary transistors, wherein the first and the second push-pull amplifier are controlled by the differential PWM signal for generating the driver signal as a differential signal. In such a configuration, the feedback stage may be configured to generate the digital error feedback signal based on a differential difference between the differential driver signal and the differential PWM signal.

The power stage may be implemented filterless. In particular, no filter components are arranged between the output or outputs of the serially connected transistor pairs and terminals for connecting the speaker.

The improved amplification concept can also be implemented with a method for generating a driver signal, in particular a driver signal for a speaker, from a multi-bit input signal. According to one implementation of such a method, a PWM signal is generated with a digital pulse-width modulation from the multi-bit input signal and a digital error feedback signal. A push-pull amplifier, e.g. a pair of serially connected complementary transistors, of a power stage, in particular a Class-D power stage, is controlled with the PWM signal for generating the driver signal. The error feedback signal is generated based on a difference between the driver signal and the PWM signal.

Generating the error feedback signal, for example, comprises generating an analog difference signal by forming a difference between a driver signal and an analog representation of the PWM signal. The analog difference signal is amplified with a first scaling factor. The amplified analog difference signal is converted to a digital difference signal. The error feedback signal is provided as a result of a digital amplification of the digital difference signal with a second scaling factor that is equal or approximately equal to an inverse of the first scaling factor. As mentioned before for implementations of the Class-D amplifier, the same relationship between the first and the second scaling factor with respect to an exact inverse also applies here.

In some implementations generating the PWM signal comprises digitally filtering a combination of the multi-bit input signal, the error feedback signal and a PWM feedback signal for generating a filtered signal, sampling the filtered signal for generating a sampled signal and producing the PWM signal from the sampled signal. The PWM signal is provided with a reduced sampling rate as the PWM feedback signal.

For example, the sampling step is performed with a first processing rate, a digital filtering step is performed with a second processing rate, which is the reduced sampling rate, and the PWM signal is output with a third processing rate. In such a configuration the second processing rate is higher than the first processing rate and lower than the third processing rate.

The PWM feedback signal with the reduced sampling rate is provided via a single stage decimator, in particular via a cascaded integrator-comb, CIC, filter, more particularly via a single stage CIC filter.

Further implementations of the method, for example, with respect to a differential implementation, become apparent to the skilled reader from the various implementations described for the Class-D amplifier.

The improved amplification concept will be described in more detail in the following with the aid of drawings. Elements having the same or similar function bear the same reference numerals throughout the drawings. Hence their description is not necessarily repeated in following drawings.

In the drawings:

Figure 1　shows an exemplary implementation of a Class-D amplifier according to the improved amplification concept;

Figure 2　shows an example implementation of a digital PWM stage;

Figure 3　shows a further example implementation of a digital PWM stage;

Figure 4　shows a further example implementation of a Class-D amplifier according to the improved amplification concept; and

Figure 5　shows a detail of an example implementation of a feedback stage.

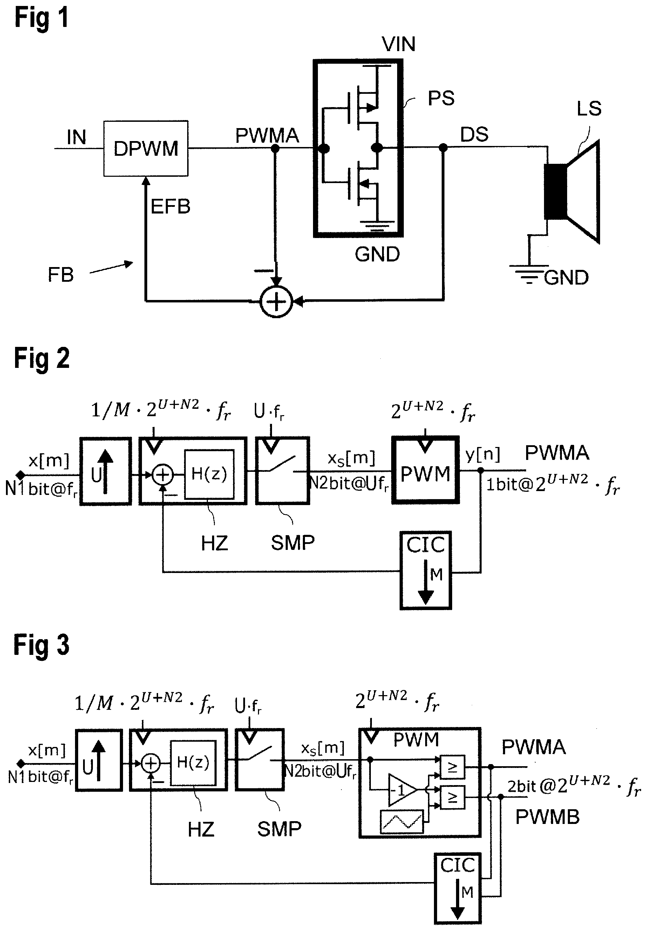

Figure 1 shows a schematic block diagram of an example implementation of a Class-D amplifier for generating a driver signal DS, in particular for a speaker LS from a multi-bit input signal IN. The speaker LS is not part of the amplifier and is shown only for illustrational reasons. For example, the speaker LS could be replaced with any resistive-inductive load in other applications of the Class-D amplifier.

The amplifier comprises a digital pulse width modulation, PWM, stage DPWM that receives the input signal IN and an error feedback signal EFB. A power stage PS is connected to the output of the digital PWM stage DPWM for receiving a PWM signal PWMA. The power stage PS in this example is implemented with at least one pair of serially connected complementary transistors being controlled by the signal PWMA that controls the serially connected transistors for generating a driver signal DS provided to the speaker. The complementary transistors are connected between a supply terminal VIN and a reference terminal GND, for example. The reference terminal GND may be a ground terminal but can be any other suitable reference potential in other implementations. The power stage PS may include further driver circuitry for driving the gate terminals of the transistors if, for example, the power level of the PWM signal PWMA is not sufficient itself. Generally, the power stage PS may include other implementations of a push-pull amplifier instead of the pair of serially connected complementary transistors.

In the shown embodiment, the power stage PS is implemented filterless. In particular, no filter components are arranged between the output of the serially connected transistor pair and terminals for providing the driver signal DS to the speaker SP.

The amplifier comprises a feedback stage FB that generates the error feedback signal EFB based on a difference between the driver signal DS and the PWM signal PWMA.

The digital PWM stage DPWM preferably performs noise shaping and generates a close to ideal PWM signal. However, the power stage PS usually introduces analog errors, for example due to power supply perturbations, slew rate, dead time etc. Error correction is done by measuring the errors introduced by the power stage PS and feeding it back to the digital PWM stage DPWM including noise shaping.

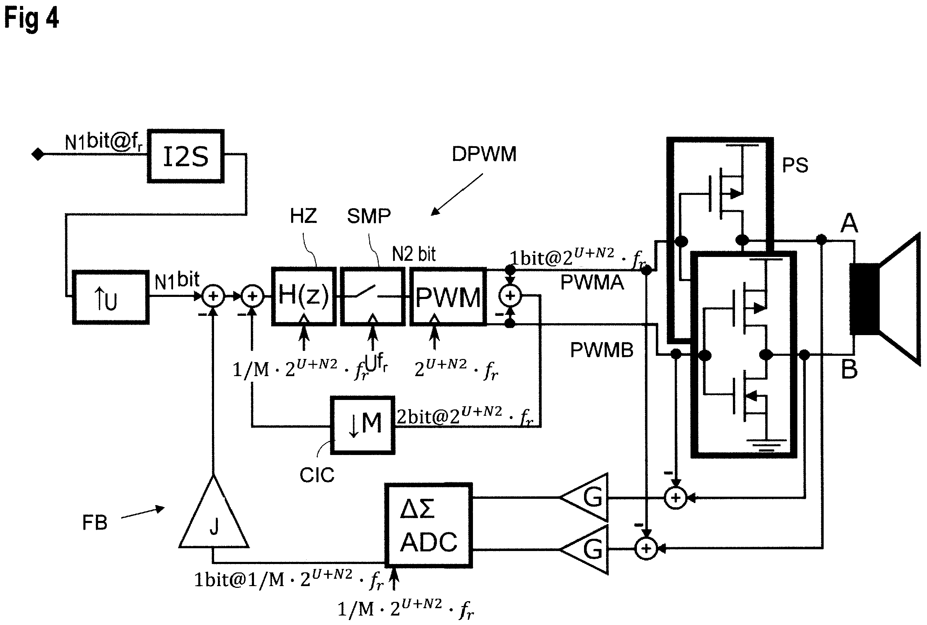

In this example implementation not a complete output signal respectively driver signal DS is measured, but only the error of the power stage PS is sensed. The error is determined by subtraction of the quasi ideal PWM signal PWMA from the driver signal DS. Processing of the signals or the error may be performed with an ADC, in particular a delta-sigma ADC, which will be explained in more detail later with respect to the implementation of Figure 4. The error introduced in the driver signal DS may be rather small and be, for example, less than 1% of the driver signal DS. Processing of this small signal relaxes requirements of the feedback path compared to a full feedback of a representation of the driver signal itself. Performance of the error correction with the feedback stage FB and processing of the error feedback signal EFB is increased if the accuracy, in particular the linearity of the digital PWM is increased.

A good linear performance may, for example, be achieved with digital pre-processing, for example non-linear predistortion of the digital input signal, but such implementations require high computational effort. However, such computational effort comes with higher power consumption which is of limited practical use in mobile applications with limited power storage. Hence, other implementations of digital PWM may be preferred.

For example, Figure 2 shows an example implementation of a digital PWM stage that can be used in the implementation example of Figure 1. A digital PWM stage receives a discrete digital input signal x[m] with N1 bit word length at a sampling rate $f_r$. This signal x[m] may be upsampled by a factor U with an upsampling stage that is optional. The main core of the digital PWM stage includes a digital filter HZ followed by a sampling element followed by a PWM generator and a single stage decimator CIC for providing the PWM signal y[n] PWMA with a reduced sampling rate to a difference element upstream to the digital filter HZ. The digital filter HZ, the sampling element SMP, the PVM generator and the feedback with the decimator CIC form a noise shaping loop for minimum non-linearity.

The sampling element SMP is clocked with a first sampling rate

$$U \cdot f_r.$$

The digital filter HZ is operated with a second sampling rate

$$1/M \cdot 2^{U+N2} \cdot f_r.$$

and the PWM generator is clocked with a third sampling rate

$$2^{U+N2} \cdot f_r$$

which is also the output rate of the PWM signal PWMA. A conversion from the third sampling rate to the second sampling rate is performed with the decimator CIC which reduces the sampling rate by a factor M. An appropriate downsampling factor M could be 8. The reduced sampling rate achieves a reduced power consumption.

The simple, single stage decimation filter adds only a very small delay to the feedback loop, which ensures stability.

Moreover, preferably the decimator CIC only needs a single accumulator with a small bit width running at the third processing rate, which further keeps power consumption low. The output xs[m] of the sampling element SMP has a word length of N2 bit being processed at the first processing rate.

Figure 3 shows a development of the implementation of Figure 2, wherein the PWM generator is configured to provide a 2bit PWM signal PWMA, PWMB at the third processing rate. To this end the PWM generator comprises two comparators for comparing the sampled signal xs[m] with a sawtooth signal, for example, wherein one comparator directly uses the sampled signal and the other comparator uses an inverted version of this signal.

Such an implementation may, for example, be used if the power stage PS is implemented as a differential stage with two push-pull amplifiers, e.g. two pairs of serially connected complementary transistors.

Figure 4 shows a further example implementation of a Class-D amplifier that is based on the embodiment of the amplifier shown in Figure 1 and one of the embodiments of a digital PWM stage of Figure 2 or Figure 3.

In contrast to the implementation of Figure 1, the power stage PS comprises a first and a second pair of serially connected complementary transistors as push-pull amplifiers for providing a driver signal in differential form with components A and B. Each of the transistor pairs is driven by one of the differential components PWMA, PWMB of the PWM signal provided by the digital PWM stage DPWM. For each of the differential components a respective error signal is generated in the feedback stage FB.

In particular, a difference is formed between the driver signal component A and the component PWMA and between the driver signal component B and the component PWMB. The noise shaping PWM generates a close to ideal PWM signal PWMA, PWMB, but the power stage PS introduces analog errors due to power supply perturbations, slew rate, dead time etc. Error correction is done by processing the errors with an ADC and feeding it back to the noise shaper, e.g. the input of the digital filter HZ. As mentioned before, not the complete output signal is measured, but only the power stage error is sensed.

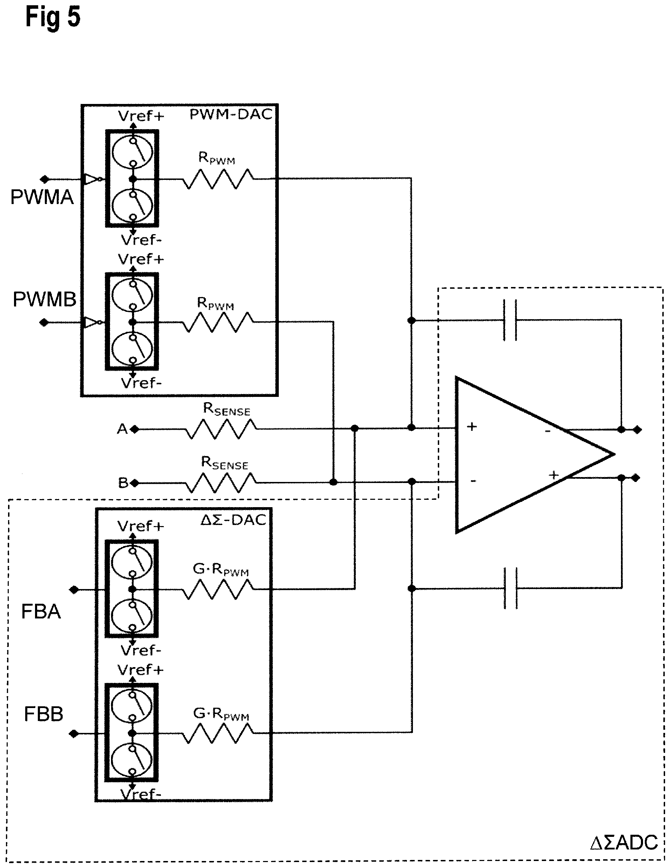

As the error between the driver signal and the PWM signal is expected to be quite small, e.g. smaller than 1% of the driver signal, the error can be amplified before being fed to the ADC in the feedback stag FB. This may significantly relax noise and linearity requirements of the ADC. The error occurs mainly at the switching edges of the power stage PS and has an impulsive character. Therefore, a continuous time delta-sigma ADC is used. For example, the ADC is built as a single bit ADC with resistive feedback DAC, which will be explained in more detail in conjunction with Figure 5. The bitstream of the delta-sigma ADC, which is operated at a processing rate of $1/M \cdot 2^{U+N2} \cdot f_r$, is digitally scaled with a second scaling factor J that is equal or approximately equal to an inverse of the first scaling factor G. Accordingly, the error is fed back with the correct order of magnitude.

The digital filter HZ, acting as a loop filter of the noise shaper, provides low pass filtering to recover the base band error present in the bitstream. The error in the power stage output received via the feedback stage FB is thereby suppressed.

The scaling with the first scaling factor G in the analog domain may be based on analog components that may be prone to process variations. Hence, an actual value of the scaling factor G may vary, in particular deviate from a nominal value. The second scaling factor J, that should be the ideal inverse of the first scaling factor G, may be implemented adjustably in order to be able to take variations of the first scaling factor G into account. For example, an actual value of the first scaling factor G may be determined during a calibration mode of operation, in particular a power up calibration. During the calibration, the feedback stage FB may be operated with a predetermined PWM sequence which allows to determine offset, positive gain and negative gain of the feedback stage FB. The second scaling factor J, which is a digital scaling factor, can be adapted on the basis of these calibration measurements.

Referring now to Figure 5, a detail of the feedback stage FB of an example implementation with a resistor network is shown. The example of Figure 5 shows a differential implementation, wherein the same principle could be used for a single-ended implementation.

The detail of Figure 5 shows an input amplifier stage of the delta-sigma ADC, in particular a first ADC integrator. At the input of this integrator, three differential signals are provided. First, the driver signal components A, B are provided via sensing resistors $R_{SENSE}$. In addition, a DAC stage for the differential PWM signal PWMA, PWMB is implemented. This PWM-DAC operates with two push-pull amplifiers, here implemented with two pairs of serially connected complementary transistors having reduced size with respect to the transistors of the power stage PS. This approach achieves a fast and highly accurate DAC having low power consumption. The output of this digital-to-analog conversion is provided to the ADC input via respective resistors $R_{PWM}$ providing appropriate signal levels.

In addition, an internal feedback of the delta-sigma ADC is provided via a delta-sigma DAC having the same structure as the PWM-DAC. The differential input signal FBA, FBB of this delta-sigma DAC corresponds to the internal digital bitstream feedback. The respective analog signals of the delta-sigma DAC are provided via resistors being scaled with respect to the resistors of the PWM-DAC, namely by the first scaling factor G.

In summary, the delta-sigma ADC is built as a continuous time single bit ADC with resistive feedback DAC. The error subtraction is implemented with a second DAC at the input of the first ADC integrator. The second DAC is driven with the PWM signal. Amplification of the error by the first scaling factor G is done with resistor ratios.

The ADC may be implemented as a second order continuous time delta-sigma ADC using a single bit quantizer. The feedback may be implemented as a resistive, non-return to zero DAC.

**Claims**

1. A Class-D amplifier for generating a driver signal, in particular a driver signal for a speaker, from a multi-bit input signal, the amplifier comprising

   - a digital pulse-width modulation, PWM, stage (DPWM) that is configured to generate a PWM signal (PWMA, PWMB) from the multi-bit input signal and a digital error feedback signal;

   - a power stage (PS) comprising a push-pull amplifier being controlled by the PWM signal (PWMA, PWMB) for generating the driver signal; and
   - a feedback stage (FB) that is configured to generate the error feedback signal based on a difference between the driver signal and the PWM signal (PWMA, PWMB).

2. The amplifier according to claim 1, wherein the feedback stage (FB) is configured to generate the error feedback signal by:

   - generating an analog difference signal by forming a difference between the driver signal and an analog representation of the PWM signal (PWMA, PWMB);
   - amplifying the analog difference signal with a first scaling factor (G);
   - converting the amplified analog difference signal to a digital difference signal; and
   - providing the error feedback signal as a result of a digital amplification of the digital difference signal with a second scaling factor that is equal or approximately equal to an inverse of the first scaling factor (G).

3. The amplifier according to claim 2, wherein the feedback stage (FB) comprises a Delta-Sigma analog-to-digital converter, ADC, ($\Delta\Sigma$ADC) for generating the digital difference signal.

4. The amplifier according to claim 2 or 3, wherein the feedback stage (FB) comprises a PWM digital-to-analog converter, DAC, comprising a further push-pull amplifier being controlled by the PWM signal (PWMA, PWMB) for generating the analog representation of the PWM signal (PWMA, PWMB).

5. The amplifier according to one of claims 2 to 4, wherein the feedback stage (FB) is configured to, during a calibration mode of operation, determine an actual value of the first scaling factor (G) and to set the second scaling factor to a value that is equal or approximately equal to an inverse of the actual value of the first scaling factor (G).

6. The amplifier according to one of claims 1 to 5, wherein the digital PWM stage (DPWM) comprises

   - a first input for receiving the multi-bit input signal;
   - a second input for receiving the error feedback signal;
   - a digital filter (HZ) coupled to the first input, to the second input and to a PWM feedback terminal;
   - a sampling element connected downstream of the digital filter (HZ);

- a PWM generator connected downstream of the sampling element for outputting the PWM signal (PWMA, PWMB); and
- a single-stage decimator (CIC) for providing the PWM signal (PWMA, PWMB) to the PWM feedback terminal with a reduced sampling rate.

7. The amplifier according to claim 6, wherein the single-stage decimator (CIC) is implemented with a cascaded integrator-comb, CIC, filter, in particular with a single-stage CIC filter.

8. The amplifier according to claim 6 or 7, wherein

- the sampling element is configured to process an output of the digital filter (HZ) with a first processing rate;
- the digital filter (HZ) is configured to process the input signal reduced by the error feedback signal and the PWM signal (PWMA, PWMB) at the PWM feedback terminal at a second processing rate, which is the reduced sampling rate;
- the PWM generator is configured to output the PWM signal (PWMA, PWMB) with a third processing rate; and
- the second processing rate is higher than the first processing rate and lower than the third processing rate.

9. The amplifier according to one of claims 6 to 8, wherein the digital PWM stage further comprises an upsampling stage coupled between the first input and the digital filter (HZ).

10. The amplifier according to one of claims 1 to 9, wherein

- the digital PWM stage is configured to output the PWM signal (PWMA, PWMB) as a differential signal;
- the power stage (PS) comprises the push-pull amplifier being a first push-pull amplifier and further comprises a second push-pull amplifier; and
- the first and the second push-pull amplifier are controlled by the differential PWM signal (PWMA, PWMB) for generating the driver signal as a differential signal.

11. A method for generating a driver signal, in particular a driver signal for a speaker, from a multi-bit input signal, the method comprising

- generating, with a digital pulse-width modulation, PWM, a PWM signal (PWMA, PWMB) from the multi-bit input signal and a digital error feedback signal;

- controlling a push-pull amplifier of a power stage (PS), in particular a Class-D power stage, with the PWM signal (PWMA, PWMB) for generating the driver signal; and
- generating the error feedback signal based on a difference between the driver signal and the PWM signal (PWMA, PWMB).

12. The method according to claim 11, wherein generating the error feedback signal comprises:

- generating an analog difference signal by forming a difference between the driver signal and an analog representation of the PWM signal (PWMA, PWMB);
- amplifying the analog difference signal with a first scaling factor (G);
- converting the amplified analog difference signal to a digital difference signal; and
- providing the error feedback signal as a result of a digital amplification of the digital difference signal with a second scaling factor that is equal or approximately equal to an inverse of the first scaling factor (G).

13. The method according to claim 11 or 12, wherein generating the PWM signal (PWMA, PWMB) comprises:

- digitally filtering a combination of the multi-bit input signal, the error feedback signal and a PWM feedback signal for generating a filtered signal;
- sampling the filtered signal for generating a sampled signal;
- producing the PWM signal (PWMA, PWMB) from the sampled signal; and
- providing the PWM signal (PWMA, PWMB) with a reduced sampling rate as the PWM feedback signal.

14. The method according to claim 13, wherein

- the sampling step is performed with a first processing rate;
- the digital filtering step is performed with a second processing rate, which is the reduced sampling rate;
- the PWM signal (PWMA, PWMB) is output with a third processing rate; and
- the second processing rate is higher than the first processing rate and lower than the third processing rate.

15. The method according to claim 13 or 14, wherein the PWM feedback signal with the reduced sampling rate is provided via a single-stage decimator (CIC), in particular via a cascaded integrator-comb, CIC, filter, more particular via a single-stage CIC filter.

# Fig 1

# Fig 2

# Fig 3

Fig 4

EP 3 567 722 A1

# Fig 5

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 887 543 A1 (BROADCOM CORP [US]) 24 June 2015 (2015-06-24) * paragraphs [0041] - [0046], [0052] - [0054]; figures 3,5 * * paragraphs [0071] - [0077]; figure 9 * | 1-15 | INV. H03F3/217 H03M3/00 H03F1/02 H03F1/32 H03F3/185 |
| X | EP 1 374 411 B1 (CIRRUS LOGIC INC [US]) 30 March 2005 (2005-03-30) * paragraphs [0012] - [0018]; figure 2a * | 1-15 | |
| X | US 2008/024210 A1 (PARK HAE-KWANG [KR]) 31 January 2008 (2008-01-31) * paragraphs [0031] - [0052]; figure 2 * | 1-15 | |
| A | US 2005/253649 A1 (MORISHIMA MORITO [JP]) 17 November 2005 (2005-11-17) * paragraphs [0120] - [0122]; figures 14,15 * | 1-15 | |
| A | EP 1 703 635 A1 (YAMAHA CORP [JP]) 20 September 2006 (2006-09-20) * abstract; figure 1 * | 1-15 | TECHNICAL FIELDS SEARCHED (IPC) H03F H03M |

The present search report has been drawn up for all claims

| Place of search | Date of completion of the search | Examiner |
|---|---|---|
| The Hague | 20 September 2018 | Zakharian, Andre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 17 1555

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2018

| Patent document cited in search report | | Publication date | Patent family member(s) | | Publication date |
|---|---|---|---|---|---|
| EP 2887543 | A1 | 24-06-2015 | EP 2887543 A1 | | 24-06-2015 |
| | | | US 2015180430 A1 | | 25-06-2015 |
| EP 1374411 | B1 | 30-03-2005 | AT 292335 T | | 15-04-2005 |
| | | | AU 6486501 A | | 24-12-2001 |
| | | | DE 60109823 D1 | | 04-05-2005 |
| | | | EP 1374411 A2 | | 02-01-2004 |
| | | | KR 20030024693 A | | 26-03-2003 |
| | | | US 6373334 B1 | | 16-04-2002 |
| | | | WO 0197384 A2 | | 20-12-2001 |
| US 2008024210 | A1 | 31-01-2008 | CN 101114814 A | | 30-01-2008 |
| | | | KR 100765792 B1 | | 12-10-2007 |
| | | | US 2008024210 A1 | | 31-01-2008 |
| US 2005253649 | A1 | 17-11-2005 | CN 1694350 A | | 09-11-2005 |
| | | | CN 101459411 A | | 17-06-2009 |
| | | | JP 4561459 B2 | | 13-10-2010 |
| | | | JP 2005341550 A | | 08-12-2005 |
| | | | KR 20060047660 A | | 18-05-2006 |
| | | | KR 20070064576 A | | 21-06-2007 |
| | | | KR 20070067672 A | | 28-06-2007 |
| | | | US 2005253649 A1 | | 17-11-2005 |
| | | | US 2007247223 A1 | | 25-10-2007 |
| EP 1703635 | A1 | 20-09-2006 | AT 425581 T | | 15-03-2009 |
| | | | CN 1835395 A | | 20-09-2006 |
| | | | EP 1703635 A1 | | 20-09-2006 |
| | | | JP 4802765 B2 | | 26-10-2011 |
| | | | JP 2007135177 A | | 31-05-2007 |
| | | | US 2006208794 A1 | | 21-09-2006 |
| | | | US 2009102557 A1 | | 23-04-2009 |

EPO FORM P0459

For more details about this annex : see Official Journal of the European Patent Office, No. 12/82